# EUROPÄISCHE PATENTSCHRIFT

(11) **EP 0 425 047 B1**
(45) Veröffentlichungstag und Bekanntmachung des Hinweises auf die Patenterteilung: **27.07.1994**
(21) Anmeldenummer: 90202824.0
(22) Anmeldetag: 23.10.1990
(51) Int. Cl.: H03G 11/02, G01R 19/165

(54) **Integrierte Begrenzerschaltung für Wechselspannungen**
Integrated limiting circuit for AC-voltages
Circuit limiteur intégré pour tension alternative

(30) Priorität: 27.10.1989 DE 3935844
(43) Veröffentlichungstag der Anmeldung: 02.05.1991
(73) Patentinhaber: Philips Patentverwaltung GmbH, 22335 Hamburg (DE); Philips Electronics N.V., 5621 BA Eindhoven (NL)
(72) Erfinder: Bockelmann, Gerhard-Jürgen, W-2072 Jersbek (DE)
(74) Vertreter: Peters, Carl Heinrich, Dipl.-Ing.

(56) Entgegenhaltungen:
- GB-A- 2 184 908
- US-A- 3 521 087
- US-A- 4 700 130

## Beschreibung

Die Erfindung betrifft eine Begrenzerschaltung für Wechselspannungen mit zwei, je mindestens eine Zenerdiode umfassende, gegensinnig in Serie geschaltete Gruppen von Dioden.

Eine solche Schaltung, wie sie z.B. aus US 47 00 130 bekannt ist, dient dem Zweck, eine zugeführte Wechselspannung auf einen festen Wert zu begrenzen und nachgeschaltete Schaltungsteile und Schaltungselemente vor zu hohen Spannungen zu schützen.
Dies geschieht bei der bekannten Schaltung dadurch daß, abhängig von der Polarität der Wechselspannung jeweils an einer der beiden Zenerdioden die Zenerspannung überschritten wird, wenn der Momentanwert der Wechselspannung die Summe aus der Zenerspannung der einen Dioden und die Durchlaßspannung der zweiten Diode überschreitet. Die Wechselspannung wird somit durch die Begrenzerschaltung auf diesen Wert, die Begrenzerspannung, beschränkt.

In vielen Fällen ist es wünschenswert, einen Signalstrom zur Verfügung zu haben, der anzeigt, daß in der Begrenzerschaltung ein Begrenzerstrom fließt, die angelegte Wechselspannung also auf die Begrenzerspannung begrenzt wird. Mit diesem Signalstrom können z.B. weitere Schutzmaßnahmen für die der Begrenzerschaltung nachgeschalteten Schaltungsteile ausgelöst werden. Dieser Signalstrom sollte immer in derselben Richtung fließen und von dem Begrenzerstrom, der unter Umständen große Werte annehmen kann, möglichst nicht direkt gebildet werden.

Der Erfindung liegt die Aufgabe zugrunde, eine integrierte Begrenzerschaltung der eingangs genannten Art auf einfache Weise so auszubilden, daß sie einen weitgehend vom Begrenzerstrom entkoppelten Signalstrom abgibt, sobald die Begrenzerschaltung aktiv ist.

Diese Aufgabe wird erfindungsgemäß dadurch gelöst, daß eine Diode jeder Gruppe durch einen als Diode geschalteten ersten Transistor (TZ₁, TZ₂) gebildet ist, der zusammen mit je einem weiteren Transistor (T₁, T₂) einen Stromspiegel bildet, wobei der gespiegelte Wert des durch die Zenerdioden fließenden Begrenzerstromes einen Begrenzersignalstrom (I_{S}) bildet, der einen fließenden Begrenzerstrom anzeigt.

Auf diese Weise kann mit wenigen zusätzlichen Schaltungselementen ein vom Begrenzerstrom entkoppelter Begrenzersignalstrom gewonnen werden.

Weitere Ausgestaltungen der Erfindung ergeben sich aus den Unteransprüchen.

Mit besonderem Vorteil läßt sich eine Begrenzerschaltung nach der Erfindung im Wechselspannungseingang eines Vollweg-Brückengleichrichters verwenden und zwar insbesondere dann, wenn dieser Wechselspannungseingang mit einer Zweidraht-Telefonleitung verbunden ist und die Begrenzerspannung der Begrenzerschaltung so gewählt ist, daß ein Begrenzersignal auftritt wenn ein Rufsignal auf der Telefonleitung auftritt.

Die Erfindung wird im folgenden anhand der beigefügten Zeichnungen an einigen Ausführungsbeispielen näher erläutert.

Es zeigen:
- Fig. 1: ein erstes Ausführungsbeispiel einer Begrenzerschaltung nach der Erfindung,
- Fig. 2: in schematischer Darstellung die Verwendung einer Begrenzerschaltung nach der Erfindung im Eingangszweig eines Brückengleichrichters und
- Fig. 3: ein zweites Ausführungsbeispiel einer Begrenzerschaltung nach der Erfindung.

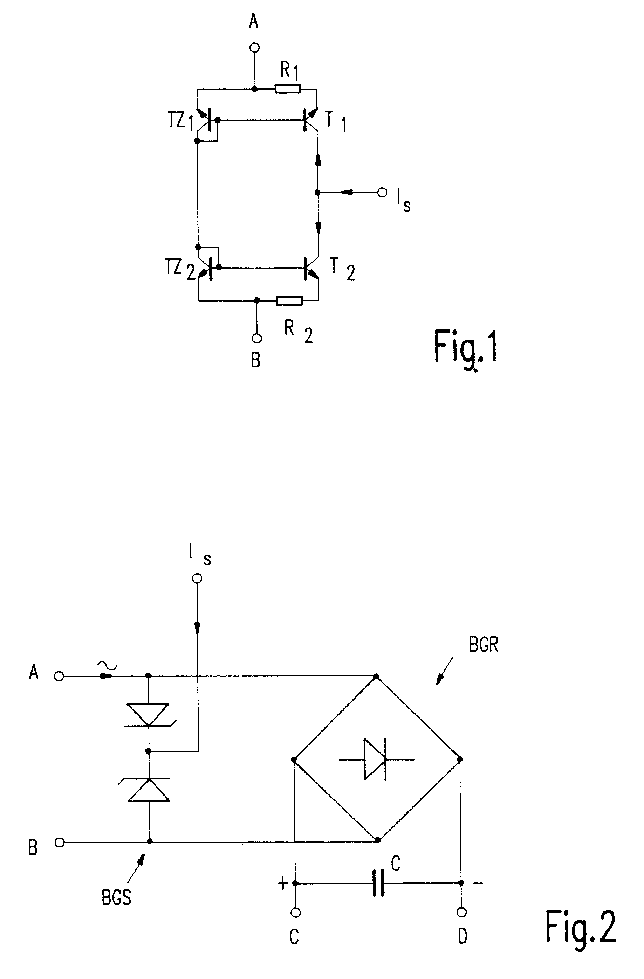

Die in Figur 1 dargestellte Begrenzerschaltung besteht aus zwei gegensinnig in Serie geschalteten Zenerdioden, die durch NPN-Transistoren TZ₁ und TZ₂ gebildet sind, deren Basen und Kollektoren jeweils miteinander verbunden sind, so daß sie als Dioden wirken. Jede Gruppe umfaßt also nur eine Diode.
Die Begrenzerspannung ergibt sich hier also aus der Summe der Zenerspannung einer der beiden Transistor-Dioden TZ₁ bzw. TZ₂ und der Durchlaßspannung der anderen Transistor-Diode TZ₂ bzw. TZ₁.
Aus dieser eigentlichen Begrenzerschaltung wird nun ein Signalstrom, der anzeigt, daß ein Begrenzerstrom von A nach B fließt dadurch abgeleitet, daß jeweils eine der beiden Transistor-Dioden mit einem weiteren Transistor einen Stromspiegel mit Transistordiode bildet, der den Begrenzerstrom in einen Begrenzersignalstrom spiegelt.
Ein solcher Stromspiegel ist an sich bekannt, z.B. aus Tietze/Schenk: "Halbleiter-Schaltungstechnik", 8. Auflage, 1986, Seite 63.

Jeder der als Diode (durch eine Verbindung zwischen Basis und Kollektor) geschalteten ersten Transistoren TZ₁ und TZ₂ bildet mit einem zweiten Transistor T₁ und T₂ dadurch einen Stromspiegel, daß die Basen und die Emitter jedes Transistorpaares TZ₁ und T₁ bzw. TZ₂ und T₂ miteinander verbunden sind. In der Emitterleitung jedes der weiteren Transistoren T₁ und T₂ liegt dabei ein Widerstand R₁ bzw. R₂, durch den das Spiegelverhältnis des so gebildeten Stromspiegels eingestellt ist.
Die Kollerktoren der als Zenerdioden wirkenden ersten Transistoren TZ₁ und TZ₂ sind miteinander verbunden. Ebenso sind die Kollektoren der beiden weiteren Transistoren T₁ und T₂ miteinander verbunden.

Die so aufgebaute Begrenzerschaltung arbeitet wie folgt:
Ist der Punkt A positiv gegenüber dem Punkt B und die anliegende Spannung gröber als die Summe aus der Zenerspannung der Transistor-Diode TZ₁ und der Durchlaßspannung der Transistor-Diode TZ₂, so fließt ein Begrenzerstrom von A nach B, der in dem aus der Transistor-Diode TZ₂ und dem weiteren Transistor T₂ gebildeten Stromspiegel mit dem gewählten Spiegelverhältnis in die Kollektorleitung des weiteren Transistors T₂ gespiegelt wird. Dieser Strom fließt dann über den weiteren Transistor T₂ zum Punkt B.
Ist dagegen der Punkt B positiv gegenüber dem Punkt A und fließt wieder ein Begrenzerstrom, d.h. ist die angelegte Spannung größer als die Summe der Zenerspannung der Transistor-Diode TZ₂ und der Durchlaßspannung der Transisistor-Diode TZ₁, so wird der Begrenzerstrom in dem aus der Transistor-Diode TZ₁ und dem weiteren Transistor T₁ gebildeten Stromspiegel mit dem eingestellten Spiegelverhältnis in die Kollektorleitung des weiteren Transistors T₁ gespiegelt. Der gespiegelte Strom, der den Begrenzersignalstrom bildet, fließt also wiederum in der gleichen Richtung diesmal durch den weiteren Transistor T₁ zum Punkt A.

Mit dieser Schaltung ist es also auf einfache Weise möglich, einen vom Begrenzerstrom fließenden Begrenzersignalstrom zu erzeugen, der von dem Begrenzerstrom entkoppelt ist, diesem proportional ist, aber um einen einstellbaren Faktor, z.B. 1.000, kleiner ist und der unabhängig von dem Augenblickswert der an die Punkte A und B angelegten Wechselspannung stets in der gleichen Richtung fließt.

Das Spiegelverhältnis, d.h. der Faktor, um den der Begrenzersignalstrom Iₛ kleiner ist als der Begrenzerstrom, kann entweder durch die in den Emitterzuleitungen der beiden weiteren Transistoren T₁ und T₂ liegenden Widerstände R₁ und R₂ eingestellt werden, oder dadurch, daß das (Emitter/Basis)-Flächenverhältnis der beiden Transistoren TZ₁ und T₁ bzw. TZ₂ und T₂ jedes Stromspiegels entsprechend gewählt wird. Die beiden Widerstände R₁ und R₂ verhindern gleichzeitig, daß die beiden weiteren Transistoren T₁ und T₂ als Zenerdioden wirksam werden.

Die Fig. 2 zeigt die Anwendung einer entsprechend der Fig. 1 ausgebildeten Begrenzerschaltung BGS im Eingangszweig eines Brückengleichrichters BGR.
Eine solche Schaltung wird z.B. im Eingangskreis von elektronischen Fernsprechapparaten an Zweidraht-Fernsprechleitungen verwendet, um einen ankommenden Rufstrom zu detektieren und ein Rufzeichen auszulösen. Kommt auf der Leitung ein Rufstrom an, so übersteigt die anliegende Spannung die voreingestellte Begrenzerspannung und die Begrenzerschaltung BGS spricht an, d.h. es fließt ein Begrenzersignalstrom Iₛ, unabhängig vom Augenblickswert der Wechselspannung stets in der gleichen Richtung. Dieser Begrenzersignalstrom Iₛ wird nun dazu verwendet, um in dem elektronischen Fernsprechapparat ein Rufsignal auszulösen.

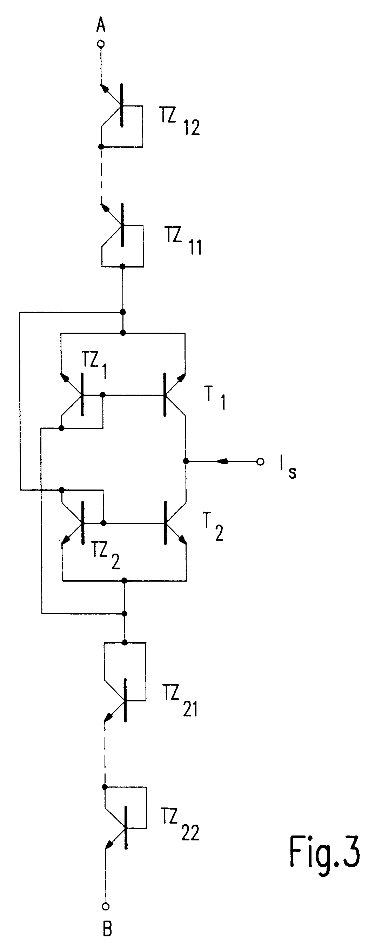

Die Fig. 3 zeigt schließlich ein weiteres Ausführungsbeispiel einer Begrenzerschaltung nach der Erfindung. Hier umfaßt jede der gegensinnig in Serie geschalteten Gruppen von Zenerdioden mindestens zwei Dioden, nämlich TZ₁ und TZ₁₁ in der einen und TZ₂ und TZ₂₁ in der anderen Gruppe, von denen jeweils mindestens eine, nämlich TZ₁₁ in der einen und TZ₂₁ in der anderen Gruppe, als Zenerdiode wirken muß. Die Diode TZ₁ bzw. TZ₂, die nicht unbedingt als Zenerdiode wirken muß, bildet zusammen mit jeweils einem weiteren Transistor T₁ bzw. T₂ auf die bereits in Fig. 1 dargestellte Weise einen Stromspiegel, durch den ein fließender Begrenzerstrom - wie bereits oben anhand der Fig. 1 beschrieben - jeweils so in die Kollektorleitungen der weiteren Transistoren T₁ und T₂ gespiegelt wird, daß er immer in der gleichen Richtung fließt.

Bei dieser Schaltung sind die Kollektoren der Transistor-Dioden TZ₁ und TZ₂ nicht miteinander, sondern jeweils mit dem Emitter der anderen beiden Transistor-Dioden TZ₂ bzw. TZ₁ verbunden. Die Begrenzerspannung ergibt sich bei dieser Schaltung also jeweils aus der Summe der Zenerspannungen der Dioden TZ₁₁ und TZ₁₂ und der Durchlaßspannungen der Dioden TZ₂, TZ₂₁ und TZ₂₂ für die eine Polarität und der Summe aus den Zenerspannungen der Dioden TZ₂₁ und TZ₂₂ und den Durchlaßspannungen der Dioden TZ₁, TZ₁₁ und TZ₁₂ für die andere Polarität der angelegten Wechselspannung.

Bei den Stromspiegeln in diesem Ausführungsbeispiel wird das Spiegelverhältnis nicht durch in den Emitterzuleitungen der weiteren Transistoren T₁ und T₂ liegende Widerstände, sondern, wie oben bereits erwähnt, durch das Emitter/Basis-Flächenverhältnis der Transistoren TZ₁ und T₁ bzw. TZ₂ und T₂ eingestellt.

Die in einer integrierten Ausführungsform Begrenzerschaltung nach der Erfindung verwendeten Schaltungselemente als solche lassen sich - im Rahmen des für die Herstellung der integrierten Schaltung verwendeten Herstellungsverfahrens - durch äquivalente Elemente ersetzen. So können z.B. die in dem Ausführungsbeispiel nach Fig. 3 verwendeten Zenerdioden statt durch Transistorstrukturen auch durch direkte Diodenstrukturen realisiert werden. Ebenso lassen sich auch die Leitungstypen der verwendeten Schaltungselemente jeweils umkehren.

## Patentansprüche

1. Begrenzerschaltung für Wechselspannungen mit zwei, je mindestens eine Zenerdiode umfassende, gegensinnig in Serie geschaltete Gruppen von Dioden,
dadurch gekennzeichnet,
daß eine Diode jeder Gruppe durch einen als Diode geschalteten ersten Transistor (TZ₁, TZ₂) gebildet ist, der zusammen mit je einem weiteren Transistor (T₁, T₂) einen Stromspiegel bildet, wobei der gespiegelte Wert des durch die ersten Transistoren fließenden Begrenzerstromes einen Begrenzersignalstrom (I_{S}) bildet, einen fließenden Begrenzerstrom anzeigt.

2. Begrenzerschaltung nach Anspruch 1,
gekennzeichnet durch
eine Verbindung zwischen de Kollektoren der beiden weiteren Transistoren (T₁, T₂) and der der Begrenzersignalstrom (I_{S}) abgenommen werden kann.

3. Begrenzerschaltung nach Anspruch 2,
dadurch gekennzeichnet,
daß jede Gruppe nur eine als Zenerdiode wirkende Transistor-Diode umfaßt, die durch jeweils einen der ersten Transistoren (TZ1, TZ2) gebildet ist, und daß die Kollektoren dieser beiden Transistoren miteinander verbunden sind (Fig.1).

4. Begrenzerschaltung nach Anspruch 2,
dadurch gekennzeichnet,
daß jede Gruppe mehrere Zenerdioden umfaßt und der Kollektor des ersten Transistors (TZ₁, TZ₂) jeder Gruppe mit dem Emitter des ersten Transistors (TZ₂, TZ₁) der jeweils anderen Gruppe verbunden ist (Fig. 3).

5. Begrenzerschaltung nach einem der vorangehenden Ansprüche,
dadurch gekennzeichnet,
daß das Spiegelverhältnis der gebildeten Stromspiegel durch einen in der Emitterzuleitung des weiteren Transistors (T₁, T₂) liegenden Widerstand (R₁, R₂) eingestellt ist.

6. Begrenzerschaltung nach Anspruch 4,
dadurch gekennzeichnet,
daß das Spiegelverhältnis der gebildeten Stromspiegel durch das Emitter-Basis-Flächenverhältnis der ersten (TZ₁, TZ₂) und zweiten (T₁, T₂) Transistoren zueinander eingestellt ist.

7. Begrenzerschaltung nach einem der vorangehenden Ansprüche,
dadurch gekennzeichnet,
daß das Spiegelverhältnis der gebildeten Stromspiegel so eingestellt ist, daß der Begrenzersignalstrom in der Größenordnung von 10⁻⁶A liegt.

8. Verwendung einer Begrenzerschaltung nach einem der vorangehenden Ansprüche im Wechselspannungseingang eine Vollweg-Brückengleichrichters.

9. Verwendung einer Begrenzerschaltung entsprechend Anspruch 8,
dadurch gekennzeichnet,
daß der Wechselspannungseingang des Brückengleichrichters mit einer Zweidraht-Telefonleitung verbunden ist und die Begrenzerspannung der Begrenzerschaltung so gewählt ist, daß eine Begrenzersignalstrom (I_{S}) auftritt, wenn ein Rufsignal auf der Telefonleitung auftritt.

## Claims

1. A limiter circuit for alternating voltages, the circuit comprising two diode groups arranged in series opposition and each group comprising at least one zener diode,
characterized in that
one diode of each group is constituted by a diode-connected first transistor (TZ₁, TZ₂), which together with a further transistor (T₁, T₂) forms a current mirror, the mirrored value of the limiter current flowing through the first transistors forming a limiter signal current (I_{S}) which indicates the flow of a limiter current.

2. A limiter circuit as claimed in Claim 1,
characterized by
a connection between the collectors of the two further transistors (T₁, T₂), on which connection the limiter signal current (I_{S}) is available.

3. A limiter circuit as claimed in Claim 2,
characterized in that
each group comprises only one diode-connected transistor operating as a zener diode, which is constituted by each time one of the first transistors (TZ₁, TZ₂), and the collectors of said two transistors are interconnected (Fig. 1).

4. A limiter circuit as claimed in Claim 2,
characterized in that
each group comprises a plurality of zener diodes and the collector of the first transistor (TZ₁, TZ₂) of each group has been connected to the emitter of the first transistor (TZ₂, TZ₁) of each time the other group (Fig. 3).

5. A limiter circuit as claimed in any one of the preceding Claims,
characterized in that
the current-mirror ratio of the current mirror formed is adjusted by a resistor (R₁, R₂) arranged in the emitter line of the further transistor (T₁, T₂).

6. A limiter circuit as claimed in Claim 4,
characterized in that
the current-mirror ratio of the current mirror formed is adjusted by the emitter-base area ratio of the first (TZ₁, TZ₂) and the second (T₁, T₂) transistors relative to each other.

7. A limiter circuit as claimed in any one of the preceding Claims,
characterized in that
the current-mirror ratio of the current mirror formed is adjusted in such a way that the limiter signal current is of the order of magnitude of 10⁻⁶ A.

8. The use of a limiter circuit as claimed in any one of the preceding Claims in the alternating voltage input of a full-wave rectifier bridge.

9. The use of a limiter circuit as claimed in Claim 8,
characterized in that
the alternating voltage input of the bridge rectifier is connected to a two-wire telephone line and the limiter voltage of the limiter circuit has been selected in such a way that a limiter signal current (I_{S}) is produced when a ringing signal appears on the telephone line.

## Revendications

1. Circuit limiteur pour tensions alternatives pourvu de deux groupes de diodes montés en tête-bêche comprenant chacun au moins une diode Zener, caractérisé en ce qu'une diode de chaque groupe est formée par un premier transistor monté en diode (TZ₁, TZ₂) qui forme avec un autre transistor (T₁, T₂) un miroir de courant, la valeur recopiée du courant de limitation traversant les diodes Zener formant un courant de signal de limitation (I_{S}) indiquant la circulation d'un courant de limitation.

2. Circuit limiteur selon la revendication 1, caractérisé par une liaison entre les collecteurs des deux autres transistors (T₁, T₂) sur laquelle peut être prélevé le courant de signal de limitation (I_{S}).

3. Circuit limiteur selon la revendication 2, caractérisé en ce que chaque groupe ne comporte qu'un seul transistor monté en diode et faisant fonction de diode Zener, transistor qui est formé par l'un des deux premiers transistors (TZ₁, TZ₂), et en ce que les collecteurs de ces deux transistors sont reliés entre eux (figure 1).

4. Circuit limiteur selon la revendication 2, caractérisé en ce que chaque groupe comporte plusieurs diodes Zener et en ce que le collecteur du premier transistor (TZ₁, TZ₂) de chaque groupe est relié à l'émetteur du premier transistor (TZ₂, TZ₁) de l'autre groupe (figure 3).

5. Circuit limiteur selon l'une quelconque des revendications précédentes, caractérisé en ce que le rapport de recopiage du miroir de courant formé est réglé par une résistance (R₁, R₂ insérée dans la connexion d'émetteur de l'autre transistor (T₁, T₂).

6. Circuit limiteur selon la revendication 4, caractérisé en ce que le rapport de recopiage du miroir de courant formé est réglé par le rapport de surface d'émetteur/base entre les premiers (TZ₁, TZ₂) et les seconds (T₁, T₂) transistors.

7. Circuit limiteur selon l'une quelconque des revendications précédentes, caractérisé en ce que le rapport de recopiage du miroir de courant formé est réglé de façon que le courant de signal de limitation est de l'ordre de grandeur de 10⁻⁶ A.

8. Application d'un circuit limiteur selon l'une quelconque des revendications précédentes à l'entrée de tension alternative d'un redresseur en pont à deux alternances.

9. Application d'un circuit limiteur selon la revendication 8, caractérisée en ce que l'entrée de tension alternative du redresseur en pont est reliée à une ligne téléphonique à deux fils et en ce que la tension de limitation du circuit limiteur est choisie de façon à faire apparaître un courant de signal de limitation (I_{S}) lors de l'apparition d'un signal d'appel sur la ligne téléphonique.
